# EUROPEAN PATENT APPLICATION

(11) **EP 1 964 818 A2**
(43) Date of publication of application: **03.09.2008**
(21) Application number: 07301050.6
(22) Date of filing: 18.05.2007
(51) Int. Cl.: C03B 23/203, C03B 11/08

(54) **Method for making microfluidic devices**

(30) Priority: 28.02.2007 EP 07300835; 28.02.2007 EP 07300836
(71) Applicant: Corning Incorporated, Corning, NY 14831 (US)
(72) Inventor: Dannoux, Thierry, 77210 Avon (FR); Marques, Paulo, 77300 Fontainebleau (FR); Morena, Robert, Caton, NY 14858 (US); Tanner, Cameron, Horseheads, NY 14845 (US)
(74) Representative: Le Roux, Martine

(57) **Abstract**

A microfluidic device (10) comprises one or more fluidic passages or channels or chambers (26,28) having one or more dimensions in the millimeter to sub-millimeter range, wherein the device (10) further comprises a consolidated mixture comprising a glass frit and a filler (20,24,22,32), the filler having a thermal conductivity greater than a thermal conductivity of the glass frit.

## Description

### BACKGROUND

Microfluidic devices as herein understood are devices containing fluidic passages or chambers having typically at least one and generally more dimensions in the sub-millimeter to millimeters range. Partly because of their characteristically low total process fluid volumes and characteristically high surface to volume ratios, microfluidic devices can be useful to perform difficult, dangerous, or even otherwise impossible chemical reactions and processes in a safe, efficient, and environmentally-friendly way, and at throughput rates that are on the order of 100ml/minute of continuous flow and can be significantly higher.

Microfluidic devices have been made of various materials including metals, ceramics, silicon, and polymers. The shortcomings encountered with these materials are numerous.

For example, devices made of polymers typically cannot withstand temperatures of more than 200° C to 300° C over a prolonged period. Moreover, it is often difficult to control surface states effectively within such structures.

Silicon devices are expensive and incompatible with certain chemical or biological fluids. Further, the semiconductive nature of silicon gives rise to problems with implementing certain pumping techniques, such as electro-hydrodynamic pumping and electro-osmotic pumping. Still further, the lithographic techniques used in forming silicon microfluidic devices naturally produce small channels (typically less than 100 µm). Such small channels have high backpressures and have difficulty achieving production throughput requirements.

Devices made of metal are liable to corrode and are typically not compatible with certain chemical or biological fluids.

It is therefore desirable, in numerous contexts, to have microfluidic structures made of glass, or at least having reaction channels lined with glass.

Microfluidic devices made of glass have been obtained by chemical or physical etching. Etching may be used to produce trenches in a glass substrate which trenches may be sealed by a glass lid, for example. Such techniques are not entirely satisfactory, however. Isotropic chemical etching does not enable significant aspect ratios to be obtained, while physical etching is difficult to implement due to its high cost and limited production capacity. To close such the open trenches, the technique most often employed to attach or seal a lid is ionic attachment. This technique, however, is expensive and difficult to implement insofar as it is highly sensitive to dust. Moreover, the surface of each layer must be extremely flat as possible in order to provide high quality sealing.

Microfluidic devices formed of structured consolidated frit defining recesses or passages between two or more substrates have been developed in previous work by the present inventors and/or their associates, as disclosed for example in U.S. Patent No. 6,769,444, "Microfluidic Device and Manufacture Thereof" and related patents or patent publications. Methods disclosed therein include various steps including providing a first substrate, providing a second substrate, forming a first frit structure on a facing surface of said first substrate, forming a second frit structure on a facing surface of said second substrate, and consolidating said first substrate and said second substrate and said first and second frit structures together, with facing surfaces toward each other, so as to form one or more consolidated-frit-defined recesses or passages between said first and second substrates. In devices of this type, because the consolidated frit defines the fluidic passages, the passages can be lined with the glass or glass-ceramic material of the consolidated frit, even if a non-glass substrate is used.

Although devices of the type disclosed in U.S. Patent No. 6,769,444 have shown excellent performance in several reactions, yields or other performance measures of certain reactions can be very sensitive to even moderate thermal gradients or hot spots. Accordingly, it is desirable to provide a microfluidic device or microreactor minimizing such thermal gradients or hot spots.

### SUMMARY

Described herein are microfluidic device and methods for producing such that preserve the advantages of glass lined reaction channels, while having increased average thermal conductivity relative to devices of the prior art. The manufacture of such devices is also described. The advantages of the materials, methods, and devices described herein will be set forth-in part in the description which follows, or may be learned by practice of the aspects described below. The advantages described below will be realized and attained by means of the elements and combinations particularly pointed out in the appended claims. It is to be understood that both the foregoing general description and the following detailed description are exemplary and explanatory only and are not restrictive.

### BRIEF DESCRIPTION OF FIGURES

Figure 1 shows a cross-sectional view of one embodiment of a microfluidic device according to one aspect of the present invention.
Figures 2A-D show SEM photographs of coatings of glass frits used in the prior art (Figure 2A) and used in various alternative embodiments of the present invention (2B-2D).
Figure 3 shows a powder x-ray diffraction ("XRD") trace of a frit material used in another embodiment of the present invention.
Figures 4A-C show steps in an embodiment of a process according to one aspect of the present invention.
Figure 5 shows a graph showing power exchange capability of microreactors of the present invention relative to prior art microreactors.
Figure 6 shows the measured variation of thermal conductivity of a glass composite with the addition of alumina.
Figure 7 is a graph showing the variation of relative density of filled glass composite with the addition of alumina as a percentage of total volume, together with digital micrographs showing examples of the composites.

### DETAILED DESCRIPTION

Before the present materials, articles, and/or methods are disclosed and described, it is to be understood that the aspects described below are not limited to specific compounds, synthetic methods, or uses as such may, of course, vary. It is also to be understood that the terminology used herein is for the purpose of describing particular aspects only and is not intended to be limiting.

In this specification and in the claims that follow, reference will be made to a number of terms that shall be defined to have the following meanings:

Throughout this specification, unless the context requires otherwise, the word "comprise," or variations such as "comprises" or "comprising," will be understood to imply the inclusion of a stated integer or step or group of integers or steps but not the exclusion of any other integer or step or group of integers or steps.

It must be noted that, as used in the specification and the appended claims, the singular forms "a," "an" and "the" include plural referents unless the context clearly dictates otherwise. Thus, for example, reference to "a pharmaceutical carrier" includes mixtures of two or more such carriers, and the like.

Described herein are microfluidic devices manufactured from glass having increased average thermal conductivity. The microfluidic devices described herein comprise a mixture or composite, wherein the mixture or composite comprises a glass frit and a filler. The filler has a thermal conductivity greater than a thermal conductivity of the glass frit.

In summary, the filler combined with the glass frit produces a consolidated glass-containing mixture or composite with increased average thermal conductivity when compared to a consolidated glass or a consolidated glass-containing mixture ro composite that does not contain the filler. Average thermal conductivity of the consolidated mixture or composite is understood as the measured or calculated thermal conductivity of the sintered frit including any fillers and residual porosity. Calculation of average thermal conductivity includes taking the directional average of thermal conductivity for anisotropic materials. In one aspect, the composite has an average thermal conductivity that is at least 10%, or at least 20% greater than that of glass that does not contain a filler. In another aspect, the composite has an average thermal conductivity greater than 1.2 W/m/K, or greater than 1.4 W/m/K, or greater than 1.6 W/m/K.

Here the unit W/m/K may also be written W.m⁻¹.K⁻¹.

The mixture or composite is a blend of the filler and the glass frit. According to certain embodiments of the invention, this may optionally be accomplished by intimately admixing the glass frit and the filler prior to thermal processing so that the filler is evenly dispersed or integrated throughout the composite. This will ensure that the entire glass composite has a relatively uniform average thermal conductivity throughout the entire composite. According to other embodiments of the invention, pre-formed sheets or blocks of at least partially consolidated mixtures or composites may be used. In either case, the composite is not glass with merely filler coated on the surface of the glass. The glass frit and filler materials useful herein will be described below.

The glass frit is a fine particulate of any glass material that upon heating can be converted to a viscous material. A variety of materials can be used herein. In one aspect, the glass frit comprises SiO₂ and at least one other alkaline oxide, alkaline earth oxide, a transition metal oxide, a non-metal oxide (e.g., oxides of aluminum, phosphorous, or boron), or a combination thereof. In another aspect, the glass frit comprises an alkaline silicate, an alkaline earth silicate, or a combination thereof. Examples of materials useful as glass frits include, but are not limited to, a borosilicate, borosilicate with dissolved zirconia, or sodium borosilicate.

Turning to the filler, the filler is nearly or completely inert with respect to the glass frit in order to preserve the thermal and mechanical properties of the filler. When the filler is nearly or completely inert with the glass frit, the filler has no or minimal reaction within the filler/frit matrix such there is essentially no foaming, forming of undesirable new phases, cracking, and any other processes interfering with consolidation. Under these conditions it is possible to produce a composite with minimal porosity.

The filler is also generally desirably non-porous, or has minimal porosity, and possesses low surface area. The filler does not burn out during sintering like organic compounds typically used in the art. The filler can remain rigid, soften, or even melt during thermal processing. In one aspect, the filler has a softening or melting point greater than that of the glass frit. Depending upon the selection of the filler, the filler can form an oxide, which will facilitate the integration of the filler into the final mixture or composite.

As discussed above, the filler increases the average thermal conductivity of the composite. In one aspect, the filler has an average thermal conductivity greater than or equal to 2 W/m/K, greater than or equal to 3 W/m/K, greater than or equal to 4 W/m/K, or greater than or equal to 5 W/m/K. Examples of fillers useful herein include, but are not limited to, silicon carbide, aluminum nitride, boron carbide, boron nitride, titanium boride, mullite, alumina, silver, gold, molybdenum, tungsten, carbon, silicon, diamond, nickel, platinum, or any combination thereof. Below in Table 1 are some physical properties of certain fillers useful herein.

**TABLE 1**

| Fillers | α (W/m/K) | CTE x 10⁻⁷/°C | E (GPa) |
|---|---|---|---|
| Diamond | 2000 | 10 | 1200 |
| Silicon carbide | 160 | 37 | 430 |
| Aluminum nitride | 150 | 46 | 320 |
| Boron nitride | 125 | 50 | 73 |
| Carbon fibers/flakes | 125 | 30 | 225 |
| Alumina | 29 | 64 | 300 |
| Silicon | 150 | 35 | 165 |
| Silver | 430 | 190 | 103 |
| Gold | 318 | 140 | 171 |
| Molybdenum | 138 | 51 | 260 |
| Tungsten | 173 | 45 | 310 |

The amount of filler can vary depending upon, among other things, the type of glass frit selected and the desired average thermal conductivity. In one aspect, the amount of filler is greater than or equal to 5% by volume of the composite. In another aspect, the amount of filler is from 15 to 60% by volume. In yet another aspect, the amount of filler is from 35 to 55% by volume.

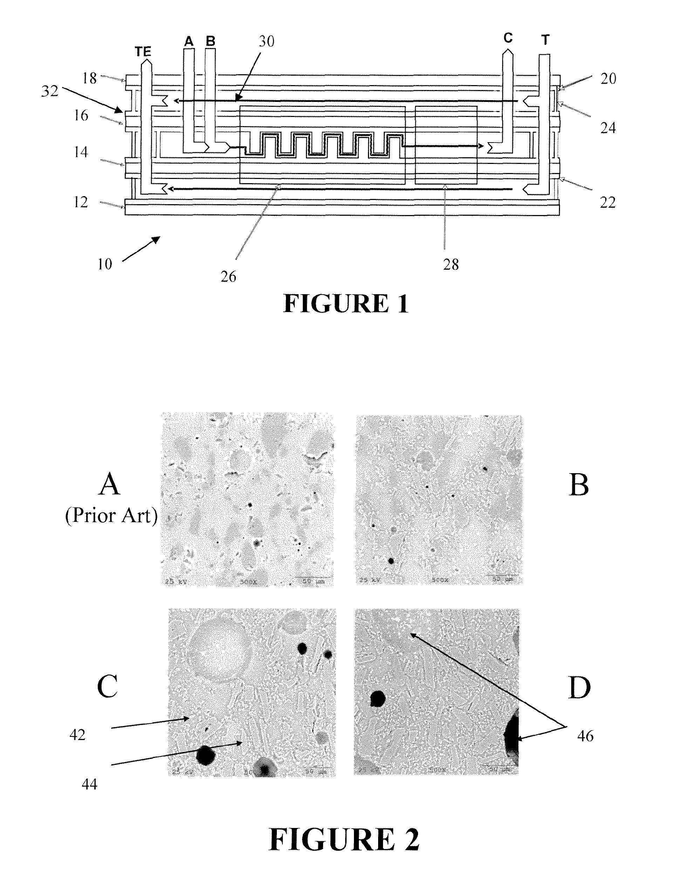

Described herein are methods for making microfluidic devices comprising mixtures or composites, the mixture or composite comprising both glass frit and filler. As mentioned above, the filler has a thermal conductivity greater than a thermal conductivity of the glass frit. According to the present invention, and with reference to Figure 1 as one type of embodiment of the present invention, the mixture or composite is formed into a consolidated body 10 having fluidic passages or channels or chambers 26, 28 having one or more dimensions in the millimeter to sub-millimeter range. The mixture may be provided by forming or providing a mixture comprising a glass frit and a filler and a binder. Forming the mixture into a consolidated body may then comprise molding the mixture, then debinding and sintering the mixture. This molding or forming processes may include: (1) forming a glass composition comprising a glass frit and a filler onto a first substrate, such as substrates 12,14,16,18. This forming may take the form of thermoforming using a mold, or another forming method, to form a first assembly comprising the first substrate 18 and the formed frit thereon 20,24. In the process relating to Figure 1, the formed frit 20, 24 on substrate 18 typically includes a thin layer 20 and wall structures 24. After the frit 20,24 is formed, then (2) the first assembly is stacked together with a second assembly comprising a second substrate 16, such that the formed glass composition 20,24 is positioned between the first substrate 18 and the second assembly, and (3) the assembled first assembly and second assembly are heated together to a temperature sufficient to consolidate the glass composition so as to form a one-piece microstructure defining at least one recess such as passages 26,28 or thermal fluid passage 30 between the first and second substrates 18, 16.

At the time of assembly, the second assembly may comprise a glass composition having been formed on the second substrate, such as a flat layer 32 or a structured layer of a glass composition comprising glass frit and a filler. In this case, the respective formed glass compositions 20,24 and 32 may be placed adjacent each other in the step of assembling, such that, upon heating, the adjacent portions of the respective formed glass compositions are consolidated together to form a one-piece microstructure 10 defining at least one recess 26,28,30 between the first and second substrates. Examples of substrate materials include, but are not limited to, alumina, silicon carbide, silicon aluminum nitride, silicon nitride, or a combination thereof. In another aspect, the substrate can be glass, such as Eagle® or other fusion-drawn glass manufactured by Corning Incorporated.

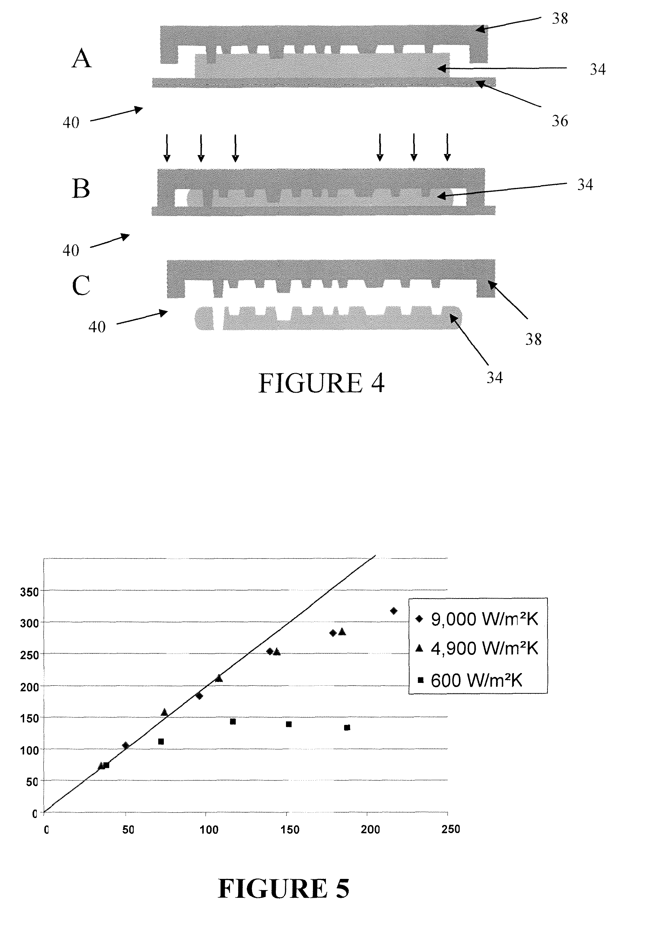

In other aspects, a substrate is optional only, and not required in order to form a microfluidic device. For example, as illustrated schematically in elevational cross section of Figures 4A-4C, a structured layer of glass composite, such as a layer in the general shape of a substrate plus walls or other structures formed thereon, may be formed entirely of a composite material by the following steps: (1) disposing a mixture of glass frit and filler 34 on a support 36; (2) disposing a first mold 38 on the mixture 34 to produce a stacked system 40; (3) heating the stacked system 40 for a sufficient time and temperature to convert at least some glass components of the mixture to a viscous glass, wherein the first mold 38 penetrates the mixture 34 as shown in Figure 4B, and the mixture 34 becomes at least somewhat consolidated, forming a consolidated glass and filler mixture or composite; (4) cooling the stacked system 40; and (5) removing the mixture or composite 34 from the first mold 38, wherein the mixture or composite 34 does not stick to the first mold 38 when the mixture or composite 34 is removed from the first mold 38. Of course the order of stacking may also be reversed, such that the mixture 34 is disposed on the first mold 38, and the support 36 is then disposed on the mixture 34. The support 36 may itself take the form of a second mold such that both surfaces of the resulting mixture or composite 34 may be intricately structured in one heating step, if desired. As mentioned above, the mixture 34 of glass frit and filler originally disposed on a support 36 can optionally take the form of pre-formed sheets 34 or blocks 34 of at least partially consolidated mixtures or composites.

One of the many advantages of this method is that upon cooling of the molded mixture or composite 34, the molded mixture 34 can easily be removed from the mold 38 by hand and not by typical techniques such as etching, which require additional time-consuming steps. Here, the molded glass mixture 34 does not stick to the mold 38. The phrase "not stick" as used herein is defined as nominal to no mechanical or chemical interaction between the molded composite and the mold.

The selection of the glass frit/filler material and of the material used to produce the mold 38 influences whether or not the molded glass will or will not stick to the mold. Properties to consider when selecting the glass and mold material include the coefficient of thermal expansion (CTE), the Young's modulus, the porosity of the mold, and the chemical stability of the mold. Each is described in detail below.

With respect to the CTE, it is desirable in certain aspects that the CTE of the mold material be close to that of the CTE of the glass to be molded. In one aspect, the first mold preferably comprises a material having a coefficient of thermal expansion within 10 x 10⁻⁷/°C at 300 °C of that of the coefficient of thermal expansion of the glass frit/filler composite.

The Young's modulus of the mold material and glass composite is another consideration, and it is related to the CTE. If the mold material has a low Young's s modulus, the mold material is more elastic and can tolerate greater CTE differences between the glass composite and the mold. Conversely, if the mold material has a high Young's modulus, the mold material is less elastic (i.e., more stiff), and the difference between the CTE of the mold material and the glass composite should be kept smaller. In one aspect, the first mold comprises a material having a Young's modulus less than the Young's modulus of the glass composite.

With respect to the material used to make the mold, the porosity and chemical stability of the mold are to be considered in addition to the CTE/Young's modulus of the mold material relative to the glass composite. With respect to porosity, the mold preferably possesses a certain degree of porosity so that gases produced during thermal treatment can escape the molten glass through the porous mold and not be entrapped in the glass. Alternatively, molding could be performed under vacuum so that entrapped or out-gassing gasses may be removed. In one aspect, the first mold has an open porosity greater than 5%, that is, greater than 5% of the volume of the mold is open. In another aspect, the first mold has an open porosity of from 5% to 20%, or about 10%.

Another consideration when selecting the mold material is that the mold should be chemically stable at elevated temperatures, particularly those required to convert the glass sheet to molten glass. The term "chemically stable" as used herein with respect to the mold material is defined as the resistance of the mold material to be converted from an inert material to a material that can interact with the molten glass. For example, when the mold is composed of boron nitride, boron nitride can be converted to boron oxide at temperatures greater than 700 °C. Boron oxide can chemically interact with glass, which results in the glass sticking to the mold. Thus, depending upon the temperature at which the molding process will be conducted, one of ordinary skill in the art can select mold materials that are not converted to chemically active materials at elevated temperatures.

Examples of mold materials useful herein include, but are not limited to, the graphite, a boron nitride ceramic, or a combination thereof. In one aspect, the mold material comprises grade 2450 PT graphite manufactured by Carbone Lorraine. This grade of graphite has a CTE of 25 x 10⁻⁷/°C at 300 °C and open porosity level of about 10%. Conventional techniques such as CNC machining, diamond ultra high speed machining, electro discharge machining, or a combination thereof can be used to make specific molds. The mold design can vary depending upon the desired features.

In this process, a mixture of glass frit and filler 34 in the form of powder 34 or of a pre-formed sheet or block 34 is placed on a support 36, followed by the placement of the mold 38 on the other side of the mixture 34. It is desirable that the support 36 be as flat or horizontal as possible to ensure even flow of the softened mixture 34. The support 36 and the mold 38 can be composed of the same or different materials. In one aspect, the support 36 comprises graphite, a boron nitride ceramic, or a combination thereof. In another aspect, when the support and mold are composed of the same material, the material is grade 2450 PT graphite manufactured by Carbone Lorraine.

In certain aspects, a release agent can be used to prevent sticking of the molded glass to the mold. The release agent can be applied to any surface of the mold, the glass sheet, and the support. The amount of release material that can be applied can vary. It is desirable that the mold material and release agent have similar properties or be composed of similar materials. For example, when the mold is composed of graphite, the release agent is carbon soot.

### EXAMPLES

The following examples are put forth so as to provide those of ordinary skill in the art with a complete disclosure and description of how the materials, articles, and methods described and claimed herein are made and evaluated, and are intended to be purely exemplary and are not intended to limit the scope of what the inventors regard as their invention. Efforts have been made to ensure accuracy with respect to numbers (e.g., amounts, temperature, etc.) but some errors and deviations should be accounted for. Unless indicated otherwise, parts are parts by weight, temperature is in °C or is at ambient temperature, and pressure is at or near atmospheric.

### Preparation and Characterization of Alumina-Filled Frits

Alumina has a thermal conductivity that is thirty-fold higher than silicate glasses. It has a thermally conductivity of α=28 W/m/K. The strength of fine-grained alumina is typically 3-5 times greater than glass, 350 versus 100 MPa. Alumina is five times stiffer than glass and better able to resist bending stresses from pressures within a capillary channel. Alumina is also an industry standard. It is inexpensive and readily available from several commercial sources such as Kyocera and CoorsTek. Alumina can also be especially resistant to chemical attack, like alkali borosilicate glasses such as Pyrex 7740 are.

Alumina filled frits with high thermal conductivity were developed for reasonable CTE matching for use with alumina substrates. A base glass composition matched in expansion to alumina was obtained with a mechanical mixture of 72% by weight of glass composition A with 28% by weight of glass composition B, with the compositions as given in **Table 2** below.

**TABLE 2**

| % mol | A | B |
|---|---|---|
| | | |
| SiO₂ | 68.97 | 70.2 |
| B₂O₃ | | 20.4 |
| Al₂O₃ | 11.41 | 3.4 |
| Li₂O | | 1.4 |
| Na₂O | 9.64 | 2.3 |
| CaO | 4.64 | 1.1 |
| MgO | 1.88 | |
| K₂O | 1.78 | |
| ZrO₂ | 1.69 | |
| F | | 1.3 |

The softening points of glass composition A and glass composition B are 683 and 757°C, respectively. The composition B frit particles in the mixture will remain more rigid during sintering and can also be viewed as a soft filler within the composition A as the bulk glass. The frits were dry ground and sieved through a screen with 63 µm openings before mixing. The alpha alumina filler was a 3:2 mixture of KC#50 (K.C. Abrasive Company, LLC, 3140 Dodge Road, Kansas City, KS 66115, 913-342-2900) and A-3000 (Almatis, Inc. 1-800-643-8771) powders. The alumina filler was added to the base glass frit in concentrations of 0, 30, 40, and 50 volume percent. Pastes for molding were obtained by mixing the frits with ~ 16 weight percent MX-4462 wax (CERDEC, a division of Ferro).

Samples for measurement of thermal conductivity were prepared by melting the frit pastes at 100 °C onto alumina substrates and pressing to form a -0.5-0.8 mm thick coating. All samples were fired for 2 hours. Sintering temperatures were selected based upon filler concentration, 0% at 705 °C, 30% at 825 °C, 40% at 1,050 °C, and 50% at 1,200 °C. SEM photographs of polished cross-sections of the composite coatings are shown in Figures 1A-1D. Thermal conductivity of the consolidated mixtures or composites was measured in two ways: (1) finite element analysis of the SEM images using the OOF software package developed at NIST (http://www.ctcms.nist.gov/oof/) and (2) a combination of laser flash measurement for thermal diffusivity at an external laboratory (Anter Laboratories) and differential scanning calorimetry ("DSC") for heat capacity.

The OOF software package allows known thermal conductivities of pores (0 W/m/K), glass (1 W/m/K) and alumina filler (30 W/m/K) to be assigned based upon contrast of each phase in an image. An artificial static temperature gradient is then imposed and thermal conductivity is computed from dimensions of the image and calculated heat flux.

Distribution of the filler and porosity is given in Table 3. Measurement of the disribution is statistical in nature and some variation occurs at the small length scales of the SEM images. This effect is accounted for by providing real filler concentrations and porosity associated with each measurement.

The resulting computed thermal conductivities of the sintered filled frits, both normal and parallel to the substrate, are given in Table 4, based on SEM images taken at two magnifications, 500 and 1000X. As may be seen in Table 4, Thermal conductivity is dramatically increased by the addition of the alumina filler. For the 50% filler concentration and the image at 1000X, the thermal conductivity of the sintered frit is increased to 5.5 W/m/K in direction normal to the substrate. Detrimental impact of porosity on conductivity can also be seen in Table 3. Fillers retard sintering thereby leading to higher levels of porosity. However, the pastes were not degassed prior to forming nor molded onto substrates within a vacuum chamber. Degassing of the paste to reduce porosity can optionally be a part of the microreactor fabrication process.

**TABLE 3**

| | Proportions of Phases in Image | | | |
|---|---|---|---|---|
| Batch | 500X | | 1000X | |
| Al₂O₃ (Vol%) | Al₂O₃ (Vol%) | Porosity | Al₂O₃ (Vol%) | Porosity |
| 30 | 24.3 | 1.9 | 28.9 | 4.2 |
| 40 | 30.8 | 15.8 | 28.2 | 17.8 |
| 50 | 38.69 | 12.2 | 55 | 0.2 |

**TABLE 4**

| Thermal Conductivity (W/m/K) | | | | | |
|---|---|---|---|---|---|
| 500X | | | 1000X | | |
| Parallel | Normal | MT-Eq. | Parallel | Normal | MT-Eq. |
| 2.13 | 1.69 | 2.04 | 2.35 | 2.06 | 2.27 |
| 2.59 | 1.67 | 2.00 | 1.74 | 1.79 | 1.78 |
| 3.59 | 2.61 | 2.74 | 7.46 | 5.49 | 5.67 |

Cylinders measuring 25 mm in diameter for laser flash measurement of thermal diffusivity were drilled from the coated substrates. Separate samples of freestanding paste in the form of pellets that were fired at the same time as the coatings were used for measurement of heat capacity by DSC. Weight of the samples with the coating and total thickness of each sample were measured, as well. Thermal diffusivities, thermal conductivities, heat capacities, and densities of the coatings are shown in Table 5. Total conductivity of the cylinders is also cited for comparison with an alumina reference button. Highest thermal conductivity was obtained at the 40% filler concentration. Conductivity decreases at the 50 volume percent filler concentration due to higher porosity as evidenced by the reduced density of the coating. It should be noted that the laser-flash measured thermal conductivity of the base glass, that is, glass with no filler, is too high at 2.2 W/m/K. Thus the absolute values in Table 5 must be questioned, but the trend is believed significant: thermal conductivities of the coatings are increased by the addition of the fillers.

**TABLE 5**

| Volume Percent Filler | Sintering Temperature (°C) | Thermal Diffusivity (cm²/s) | Heat Capacity of Frit (J/g) | Density of Frit (g/cm³) | Thermal Conductivity Total (W/m/K) | Thermal Conductivity Of Frit (W/m/K) |
|---|---|---|---|---|---|---|
| 0% | 705 | 0.021 | 0.83 | 3.08 | 5.0 | 2.2 |
| 30 | 825 | 0.028 | 0.81 | 3.05 | 6.8 | 3.7 |
| 40 | 1050 | 0.037 | 0.74 | 3.12 | 8.9 | 4.4 |
| 50 | 1200 | 0.036 | 0.73 | 2.75 | 7.6 | 4.3 |
| REF (Al₂0₃) | NA | 0.0794 | 0.78 | 3.61 | 22.3 | NA |

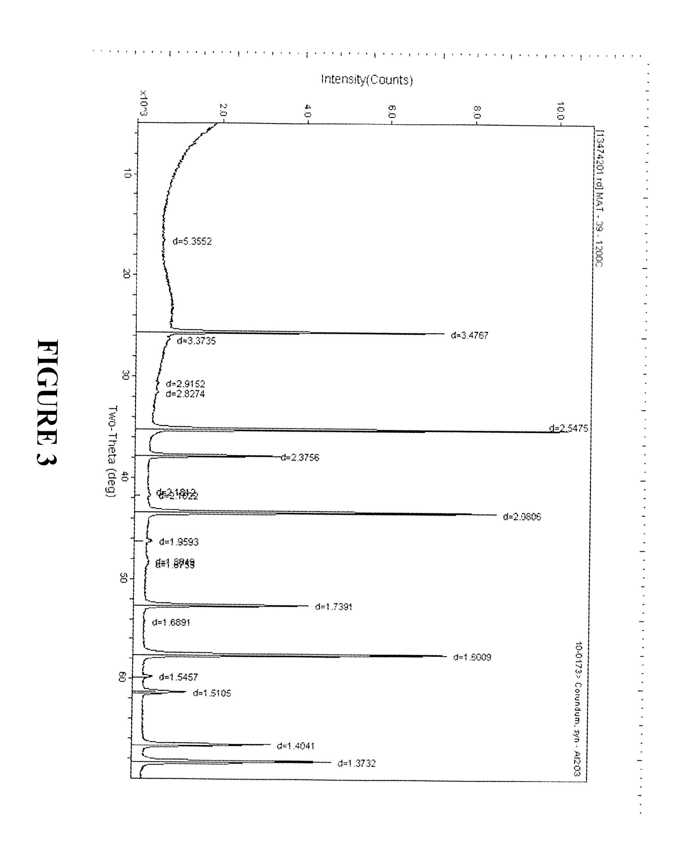

Powder XRD was performed before and after sintering on pellets of the alumina filled frits. Figure 3 shows the traces obtained for the sample containing 50 volume percent of filler after firing at 1,200 °C for 2 hours. The trace shows the characteristic glassy halo, a large quantity of α-alumina, and some mullite. The small quantity of mullite, <5%, is the product of a reaction of the filler with the silica in the glass. The alumina filler is thus essentially inert, even at 1,200 °C. Formation mullite may in fact be beneficial, as it has a thermal conductivity of 6 W/m/K. Formation of some mullite may also aid in development of a continuous network of thermally conductive material by bridging the particles of alumina filler through the glass matrix.

### Preparation of Microreactors

Microreactors were fabricated on CoorsTek 96R alumina substrates 12,14 16,18 (1.0 mm thick) from frit pastes containing 0, 30, and 50 volume percent alumina filler in the base glass. The prototypes were fabricated using the micromolding techniques outlined in U.S. Patent Nos. 6,595,232 and 6,769,444, with the following differences. First, the alumina substrates 12,14,16,18 for molding were laser cut to size and predrilled with the fluidic vias. Second, fibrous cellulose (Whatman CF-1) was used instead of calcium carbonate to control the flow of paste during the presintering thermal cycle. Third, no thin flat layer of frit-based material was applied to the heat-exchange side of the alumina substrates (no layer 22, for example, as is indicated in Figure 1). The first two changes were made to take advantage of process improvements to simplify the fabrication process. The third change was made to reduce the thermal resistance of the device. The thermal cycles were selected to give a microreactor with internal volumes and hence internal dimensions and structures that are similar to previously tested glass reactors. This was done to ensure similar hydrodynamic conditions for the thermal tests.

Individual layers were presintered prior to assembly to remove the binder and generate mechanical properties in the frit that were able to withstand the weight of stacking of the presintered layers. The presintering thermal cycle was as follows: 1) 0-300 °C at 4 °C/min; 2) dwell 120 min; 3) 300-630 °C at 4 °C/min; 4) dwell 30 min; 4) 610-25 °C at 2 °C/min. Sintering of assemblies forming the device such as device 10 was performed using a 550 g weight. The additional pressure of the weight is believed to assist in sealing of the frit structures to frit in an adjacent layer or to the alumina substrate as is necessary to create a leak-free fluidic channel. The sintering thermal cycles was: 1) 0-MAX at 2 °C/min; 2) dwell 120 min; 3) MAX at 2 °C/min; 4) dwell 60 min; 5) 400-25 °C at 2 °C/min where MAX=705, 825, 1,050, and 1,200 °C for 0, 30, and 50 volume percent filler concentrations, respectively. SEM photographs of polished cross-sections of the frit coatings are shown in Figures 2A-2D, at 0 volume percentage of filler, and 30 40 and 50% by volume, respectively. The two varied sizes of Alumina particles used are visible in Figure 2C, including the small particles 42 of the Almatis A-3000 and a large particle 44 of the K.C. Abrasive KC#50. As the percentage of filler increases from Figure 2B to Figure 2D, the presence and relative size of pores 46 also increases, as may be seen in Figure 2D.

Thermal tests were conducted to compare heat exchange performance of the alumina prototypes to previously tested glass reactors of the same size and form. The fast, exothermic reaction used in the thermal tests was that of concentrated hydrochloric with sodium hydroxide at the same concentration (6 N). The reactants were fed in at reactant ports such as reactant ports A and B represented schematically in Figure 1, and after reaction, out of port C. Ethanol was used as the heat-exchange fluid, such as by being flowed into port T in Figure 1, and out of port TE.

Results of the thermal tests are shown in Figure 5 as a plot of power exchange in watts/m²K versus the reactant flow rate in milliters per minute. The plot shows the results for the reference glass reactor (square symbols), an alumina prototype fabricated from the base glass frit without any filler (triangles), and an alumina prototype with the frit that contains 50 volume percent filler (diamonds). The alumina prototypes were capable of exchanging 2.5 to 3 times more power than the glass reactor. Heat transfer coefficients were calculated to be 450 for the reference glass reactor, 1,350 for the alumina prototype built with frit that contained no filler, and 1,400 W/m²K for the alumina prototype built with frit that contained 50% alumina filler. Material heat transfer coefficients were calculated from known material properties and frit layer thicknesses. Thickness of the flat and residual layers in the reference glass reactor was -0.2 mm each for a total of 0.4 mm. The thickness of the residual layer in the alumina prototypes was ~0.125 mm, and the flat layer thickness was 0 mm as no flat layer was used. Material heat transfer coefficients of the three types of reactors are 670, 4,900, and 9,000 W/m²K, respectively. It can be seen by comparing the material and total heat transfer coefficients for the glass reactor that the glass frit and substrate limit heat transfer. The combined contribution of the heat exchange fluid and the reactant fluids to the heat transfer coefficients can be deduced by subtraction of ~1,500 W/m²K.

Although theses particular results show the heat transfer in the alumina prototypes is limited by properties of fluids, the impact of the conductivity of the frit is still significant, as is the improved conductivity offered in the frit-based materials in the microfluidic devices of the present invention. In particular, it may be desirable to include a thin frit layer on every surface of every substrate, unlike in the prototype devices, for at least two reasons: first the thin layer may promote sealing during manufacture of the microreactor so as to increase the pressure resistance of thermal control fluid circuit, and second, use of the thin layer allows a microfluidic device to present only one material to the various reaction fluids and the heat exchange fluids that may flow within the device, thus promoting durability and inertness.

If dimensions of the residual layer were similar to the one in the reference glass reactor, and the flat layer was incorporated into the device, the calculated material heat transfer coefficients would be ∼2,300 for the alumina prototype built from frit that contained no alumina filler and ∼7,300 W/m²K for the frit with 50 volume percent alumina. Referring to the data in Tables 3 and 4, filler concentrations of at least about 30 volume percent alumina in the base glass would be required to achieve a heat transfer coefficient of 6,000 W/m²K.

### Additional Glass Materials

Other glasses were investigated: DD3009 (zirconium-containing borosilicate) and sodium borosilicate were filled with 30% by volume of KC#40 alumina filler. Specimens were synthesized by uniaxial pressing of mixed powders and followed by firing at 1,000 °C during 30 minutes. Both specimens were near fully consolidated with relative densities around 95%. The thermal conductivities for both composites were 2.1 W/m/K. The composition of glass had small impact on heat conduction.

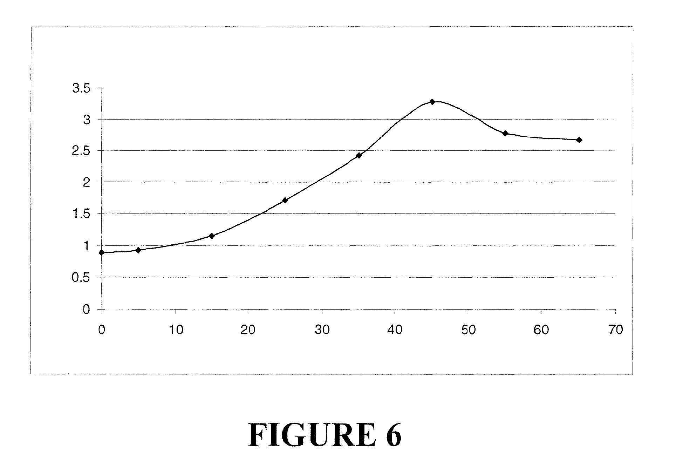

Figure 6 illustrates the variation of thermal conductivity in W/m/K with alumina filler addition measured in volume percentage. As volume fraction of filler increases, thermal conductivity of composite increases rapidly with a maximum around 35% by volume. For volume fractions above 40%, an inversion of variation of thermal conductivity was observed. This is believed to be attributable to an increase in porosity, which decreases heat conduction. Above 35% by volume, alumina filler begins to interfere with glass densification, with reasonably fair composite densities still achieved above 50%. Highest performance appears to be achieved at about 35 to about 55% by volume.

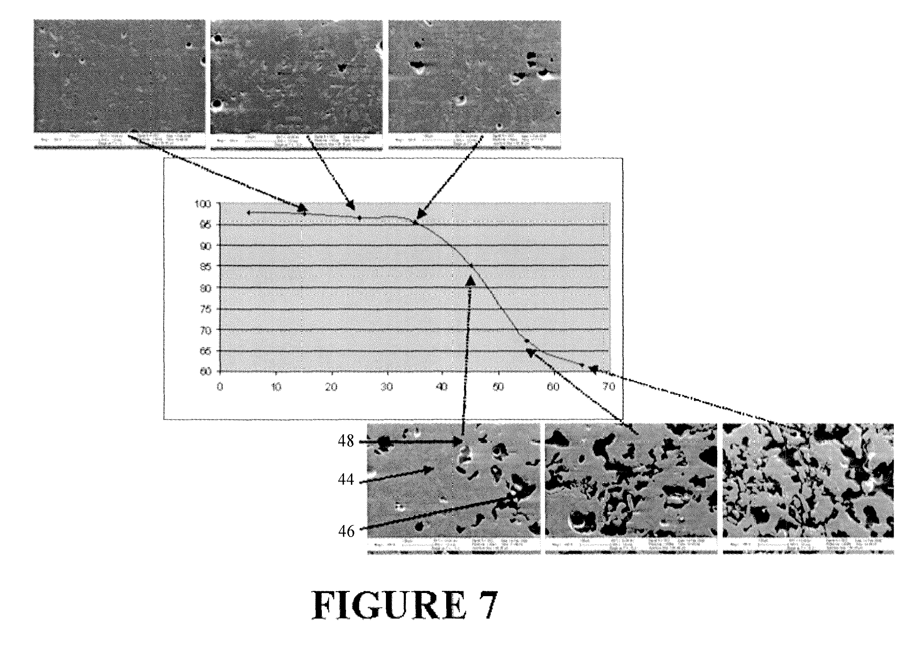

Figure 7 shows the relative percentage density of the final glass and filler consolidated mixture or composite as a function of weight percentage of alumina filler. As may be seen from the graph, weight percentages of alumina greater than about 35% begin to lower the density of the resulting consolidated mixture. The increasing porosity helps explain the peak in Figure 6. Micrographs of the consolidated mixtures at the various percentages indicated are also included in Figure 7. For the consolidated mixture having about 45% filler by volume, consolidated glass matrix 48 as well as filler 44 and pores 46 can be seen the micrograph.

Compositions of glass frit, filler, and substrate and processing conditions should be chosen to avoid unwanted reactions. For example, contact of glass material with fillers during sintering at high temperature can result in several undesired reactions. Foaming of a glass frit matrix was found to occur during sintering even in neutral atmosphere (Argon) when SiC or A1N were the fillers. Adhesion of BN filler to an alumina support has been found to be poor. Glass exudes (sweats) from diamond filler. These problems can be avoided by varying the reaction (sintering) conditions and the starting materials.

Throughout this application, various publications are referenced. The disclosures of these publications in their entireties are hereby incorporated by reference into this application in order to more fully describe the compounds, compositions and methods described herein.

Various modifications and variations can be made to the materials, methods, and articles described herein. Other aspects of the materials, methods, and articles described herein will be apparent from consideration of the specification and practice of the materials, methods, and articles disclosed herein. It is intended that the specification and examples be considered as exemplary.

## Claims

1. A microfluidic device (10) comprising one or more fluidic passages or channels or chambers (26,28) having one or more dimensions in the millimeter to sub-millimeter range, wherein the device (10) further comprises a consolidated mixture comprising a glass frit and a filler (20,24,22,32), the filler having a thermal conductivity greater than a thermal conductivity of the glass frit.

2. The device according to claim 1, wherein the glass frit comprises SiO₂ and at least one alkaline oxide, alkaline earth oxide, metal oxide, non-metal oxide, or a combination thereof.

3. The device according to claim 1, wherein the glass frit comprises an alkaline silicate, an alkaline earth silicate, or a combination thereof.

4. The device according to claim 1, wherein the glass frit comprises a borosilicate, zirconium-containing borosilicate, or alkaline borosilicate.

5. The device according to any of claims 1-4, wherein the filler has an average thermal conductivity greater than or equal to 2 W/m/K.

6. The device according to any of claims 1-4, wherein the filler has an average thermal conductivity greater than 5 W/m/K.

7. The device according to any of claims 1-6, wherein the filler comprises silicon carbide, aluminum nitride, boron carbide, boron nitride, titanium bromide, mullite, alumina, silver, gold, molybdenum, tungsten, carbon, silicon, diamond, nickel, platinum, or any combination thereof.

8. The device according to any of claims 1-7, wherein the amount of filler is greater than or equal to 5% by volume of the mixture.

9. The device according to any of claims 1-7, wherein the amount of filler is from 15% to 60% by volume of the mixture.

10. The device according to any of claims 1-7, wherein the amount of filler is from 35% to 55% by volume of the mixture.

11. The device according to any of claims 1-10, wherein the consolidated mixture has an average thermal conductivity that is at least 10% greater than that of a consolidated material composed of glass frit and no filler.

12. The device according to any of claims 1-10, wherein the consolidated mixture has an average thermal conductivity that is at least 20% greater than that of a consolidated material composed of glass frit and no filler.

13. The device according to any of claims 1-12, wherein the device further comprises a substrate.

14. The device according to claim 13, wherein the substrate comprises alumina, silicon carbide, silicon aluminum nitride, silicon nitride, or a combination thereof.

15. A method for making a microfluidic device, the method comprising:
providing a mixture, the mixture comprising a glass frit and a filler, the filler having a thermal conductivity greater than a thermal conductivity of the glass frit;
forming the mixture into a consolidated body having fluidic passages or channels or chambers having one or more dimensions in the millimeter to sub-millimeter range.

16. The method according to claim 15 wherein the step of providing a mixture comprises providing a mixture comprising a glass frit and a filler and a binder, and wherein the step forming the mixture into a consolidated body comprises molding the mixture then debinding and sintering the mixture.

17. The method according to claim 16 wherein the step of molding comprises flat molding.

18. The method according to claim 15 wherein the step of providing a mixture further comprises providing the mixture of glass frit and filler in the form of an at least partially consolidated sheet.

19. The method according either of claims 15 and 18 wherein the step of forming further comprises forming under heat using one or more molding surfaces comprising porous carbon.
